# EUROPEAN PATENT APPLICATION

(11) **EP 4 361 654 A1**
(43) Date of publication of application: **01.05.2024**
(21) Application number: 22894700.8
(22) Date of filing: 10.11.2022
(51) Int. Cl.: G01R 31/387

(54) **NEW ENERGY VEHICLE, AND ANOMALY MONITORING AND DIAGNOSIS METHOD AND DEVICE FOR BATTERY SYSTEM SOC OF NEW ENERGY VEHICLE**

(30) Priority: 16.11.2021 CN 202111356361
(71) Applicant: Yutong Bus Co., Ltd., Zhengzhou, Henan 450061 (CN)
(72) Inventor: TIAN, Ye, Zhengzhou, Henan 450061 (CN); ZHAO, Yubin, Zhengzhou, Henan 450061 (CN); CHEN, Yuqing, Zhengzhou, Henan 450061 (CN); WANG, Yongshi, Zhengzhou, Henan 450061 (CN); ZHOU, Xuesong, Zhengzhou, Henan 450061 (CN); LI, Yunxiao, Zhengzhou, Henan 450061 (CN)
(74) Representative: Gulde & Partner
(86) International application number: PCT/CN2022/131082
(87) International publication number: WO 2023/088163

(57) **Abstract**

A new energy vehicle, and an anomaly monitoring and diagnosis method and apparatus for a state of charge (SOC) of a battery system thereof. In the method, first, a displayed SOC change amount corresponding to a discharge process is determined. Then, an actual SOC change amount corresponding to the discharge process is determined according to a cumulative discharge amount of the discharge process, and a rated electric quantity and a capacity coefficient of a battery, where the capacity coefficient is related to a state of health of the battery and a temperature of the battery. Next, an SOC deviation value is calculated. Finally, a deviation range where an absolute value of the SOC deviation value lies is determined, to determine whether the battery system is abnormal. According to the method and the apparatus, the actual capacity of the battery is accurately estimated by taking the influence of the state of health of the battery and the temperature of the battery on the battery capacity into consideration, and the deviation degree of the SOC displayed on an instrument is quantified using a specific value.

## Description

### TECHNICAL FIELD

The present invention relates to the technical field of state of charge (SOC) of new energy vehicles, and specifically to a new energy vehicle, and an anomaly monitoring and diagnosis method and apparatus for an SOC of a battery system thereof.

### BACKGROUND

During the use of a new energy vehicle (including charge, discharge, and other processes that cause a change in the electric quantity of the power battery), the battery management system (hereinafter referred to as BMS) calculates the current remaining power in real time by using an algorithm in its own program according to data such as voltage, temperature, and SOH (state of health) of each cell in the power battery reported to the BMS of the vehicle as well as an SOC-OCV (open-circuit voltage) curve model of the power battery core of the vehicle, and sends same to an instrument through CAN (Controller Area Network) communication, providing visual information of the remaining power of the battery for the user to predict the mile range that the vehicle can travel, determine whether charging is needed, and so on.

When the SOC is accurately displayed, the remaining power in the battery can be accurately estimated, to provide the user with accurate vehicle use information, thereby avoiding stopping or abnormal power caused by inaccurate estimation of the remaining power during use, and ensuring the safety of the driver and passengers and good user experience. In addition, the change of the SOC can accurately reflect the current health condition of the battery, which is of great significance to the monitoring of the battery safety. An abnormal battery temperature and cell voltage, inaccurate SOH calculation, and an abnormal SOC-OCV curve model all affect the calculation of the SOC. Therefore, through the identification of an SOC anomaly, the data characteristics of the SOC anomaly can more intuitively reflect the potential safety hazards of the current battery.

At present, in the prior art, the accuracy of the SOC reported by the BMS cannot be quantified, and the occurrence of related cases can be determined only from SOC anomalies fed back by the user during use, resulting in that faults cannot be found in time, and seriously affecting user experience and the monitoring of the battery safety.

### SUMMARY

An objective of the present invention is to provide a new energy vehicle, and an anomaly monitoring and diagnosis method and apparatus for an SOC of a battery system thereof, to solve the problem in the prior art that faults cannot be found in time and the user experience is affected due to the inability to quantify the deviation degree of the SOC displayed on the instrument.

To solve the above technical problems, technical solutions provided in the present invention and beneficial effects corresponding to the technical solutions are as follows.

The present invention provides an anomaly monitoring and diagnosis method for an SOC of a battery system of a new energy vehicle, which includes the following steps:
1) acquiring an initial state of charge SOCᵢₙᵢₜᵢₐₗ and a final state of charge SOC_{final} corresponding to a discharge process of a battery and displayed on an instrument of the new energy vehicle, and calculating a difference between the two states of charge to obtain a displayed SOC change amount ΔSOC_{displayed} corresponding to the discharge process;
2) determining an actual SOC change amount ΔSOC_{actual} corresponding to the discharge process according to a cumulative discharge amount of the discharge process, and a rated electric quantity and a capacity coefficient of the battery, where the capacity coefficient is related to a state of health of the battery and a temperature of the battery;
3) calculating a difference between the displayed SOC change amount ΔDOC_{displayed} and the actual SOC change amount ΔSOC_{actual} to obtain an SOC deviation value k; and
4) determining a deviation range where an absolute value |k| of the SOC deviation value k lies, to determine whether an SOC anomaly occurs in the battery system, where the deviation range is defined according to a deviation threshold, the deviation threshold includes a first deviation threshold K3, it is determined that no SOC anomaly occurs in the battery system if |k| ∈ [0,K3), and it is determined that an SOC anomaly occurs in the battery system if |k| ∈ [K3,+∞).

The above technical solution has the following beneficial effects: In the present invention, the actual capacity of the battery is accurately estimated by taking the influence of the state of health of the battery and the temperature of the battery on the battery capacity into consideration. Based on this, an actual SOC change amount corresponding to a discharge process of the battery is obtained, and then the actual SOC change amount is compared with a displayed SOC change amount corresponding to the discharge process and a difference between them is calculated. In this way, the deviation degree of the SOC displayed on an instrument is quantified using a specific value, and a fault can be quickly found according to the difference, so as to preliminarily analyze and predict a fault type of the SOC of the battery system, thereby providing a particular dimension for anomaly analysis, and facilitating further troubleshooting of the SOC of the battery system.

Further, to accurately calculate the actual capacity of the battery, in the step 2), the capacity coefficient is a product of the state of health of the battery and a temperature coefficient, and the temperature coefficient is related to the temperature of the battery.

Further, to further refine the deviation range to achieve accurate fault locating, in the step 4), the deviation threshold further includes a deviation threshold greater than the first deviation threshold K3, and for deviation ranges defined according to the deviation threshold greater than or equal to the first deviation threshold K3, each deviation range corresponds to an anomaly cause; and after it is determined that an SOC anomaly occurs in the battery system, a corresponding anomaly cause is determined according to the deviation range where the absolute value |k| of the SOC deviation value k lies.

Further, to further refine the deviation range to achieve accurate fault locating, the deviation threshold greater than or equal to the first deviation threshold K3 further includes a second deviation threshold K2, and K2>K3; and if |k| ∈ [K3,K2), it is determined as a mild fault occurs, and the corresponding anomaly causes include: a correction strategy used by a battery management system to calculate a battery SOC to be displayed is abnormal.

Further, to further refine the deviation range to achieve accurate fault locating, the deviation threshold greater than or equal to the first deviation threshold K3 further includes a third deviation threshold K1, and K1>K2; and if |k| ∈ [K2,K1), it is determined as a serious fault occurs, and the corresponding anomaly causes include at least one of them: the battery has been used for more than a set life threshold, a total number of charge and discharge cycles of the battery is greater than a set cycle threshold, and a correction strategy used by a battery management system to calculate a battery SOC to be displayed is abnormal.

Further, to further refine the deviation range to achieve accurate fault locating, the deviation threshold greater than or equal to the first deviation threshold K3 further includes a third deviation threshold k₁, and k₁>K1; and if |k| ∈ [K1,k₁), the corresponding anomaly causes include at least one of them: a number of times of charging of the battery is greater than a set charging number threshold, and estimation of the state of health of the battery is abnormal.

Further, to further refine the deviation range to achieve accurate fault locating, if |k| ∈ [k1,+∞), the corresponding anomaly causes include: data used by the battery management system to calculate the battery SOC to be displayed is abnormal, and data used by the battery management system to calculate the state of health of the battery is abnormal.

Further, to solve the problem of inaccuracy caused by manual identification and definition of the deviation range, a method of determining the deviation threshold includes:
acquiring a plurality of discharge processes, and obtaining a plurality of SOC deviation values k by using the same method as that used in the steps 1) to 3);
fitting a normal distribution curve with the SOC deviation value k as an abscissa and a number of times of appearance of the SOC deviation value k as an ordinate; and
determining the deviation threshold according to a 3σ criterion of normal distribution.

The present invention provides an anomaly monitoring and diagnosis apparatus for an SOC of a battery system of a new energy vehicle, which includes a memory and a processor. The processor is configured to execute instructions stored in the memory to implement the anomaly monitoring and diagnosis method for an SOC of a battery system of a new energy vehicle, and achieve the same beneficial effects as the method.

The present invention provides a new energy vehicle, which includes a vehicle body and further includes the anomaly monitoring and diagnosis apparatus for an SOC of a battery system of a new energy vehicle, and achieve the same beneficial effects as the apparatus.

### BRIEF DESCRIPTION OF THE DRAWINGS

FIG. 1 is a schematic diagram showing comparison between an SOC displayed on an instrument and an actual SOC when an SOC deviation value k is less than 0 according to the present invention;
FIG. 2 is a schematic diagram showing comparison between an SOC displayed on an instrument and an actual SOC when an SOC deviation value k is greater than k1 according to the present invention;
FIG. 3 is a flowchart of an anomaly monitoring and diagnosis method for an SOC of a battery system of a new energy vehicle according to the present invention; and
FIG. 4 is a structural diagram of an anomaly monitoring and diagnosis apparatus for an SOC of a battery system of a new energy vehicle according to the present invention.

### DETAILED DESCRIPTION

The basic concept of the present invention is as follows: An actual capacity of a battery is accurately determined according to a state of health and a temperature of the battery. It is identified according to the actual capacity of the battery whether an SOC of the battery calculated by a BMS has an anomaly causing a difference between an SOC displayed on an instrument and an actual SOC. A current fault of the battery is fed back according to the difference. Based on the concept, an anomaly monitoring and diagnosis method and apparatus for an SOC of a battery system of a new energy vehicle, and a new energy vehicle of the present invention are described in detail.

### Method embodiment:

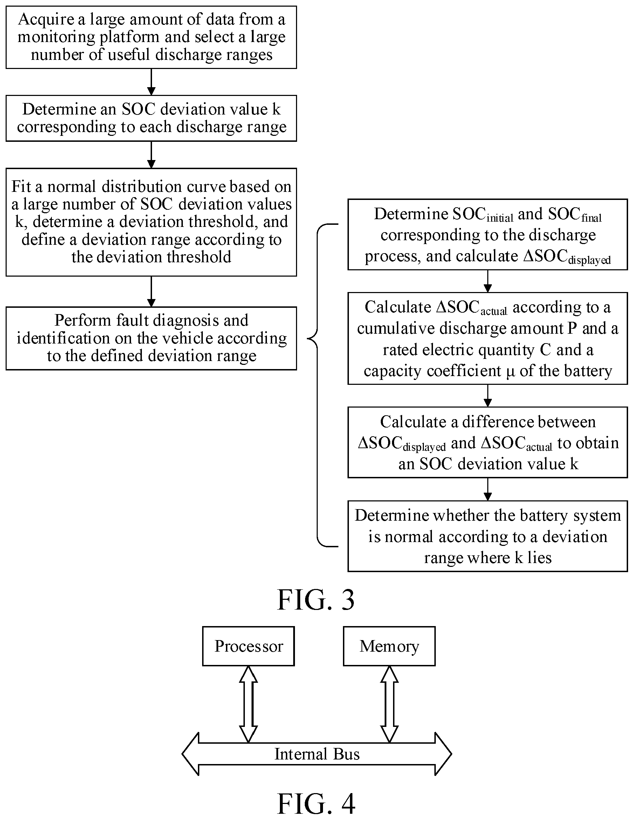

An embodiment of the present invention provides an anomaly monitoring and diagnosis method for an SOC of a battery system of a new energy vehicle. FIG. 3 shows an overall flowchart of the method. The specific process is as follows:

In a first step, data is acquired from a database of a monitoring platform, and the acquired data is preliminarily processed. Details are as follows:
1. Detailed information corresponding to a type of vehicle is acquired from the database of the monitoring platform. The detailed information includes basic information of the vehicle, date, battery SOC (hereinafter referred to as SOC), minimum temperature of a single cell, electric quantity of a single discharge, state of health of the battery (hereinafter referred to as SOH), and other data details.
2. All the acquired data is filtered and cleaned to acquire a discharge range meeting requirements (where one discharge range corresponds to one discharge process). The data filtering and cleaning is related to the vehicle. For example, a discharge range of [40%, 30%] needs to be selected for some vehicles, and a discharge range of [90%, 70%] needs to be selected for some vehicles. The filtering and cleaning is performed according to an actual vehicle requirement. In addition, the data filtering and cleaning further includes filtering out some data that obviously has errors.
3. A temperature coefficient k_{T} that corresponds to the temperature of the battery in each discharge process and a state of health SOH of the battery are acquired. Because the temperature has impact on the battery capacity, an accurate battery capacity needs to be determined by taking the temperature into consideration, in order to obtain an accurate SOC change amount ΔSOC_{actual}. A correspondence between the temperature of the battery and the temperature coefficient may be obtained by experimental calibration. The state of health SOH of the battery is calculated by the BMS.
4. The first piece of data and the last piece of data in a discharge range, i.e., an initial state of charge SOCᵢₙᵢₜᵢₐₗ and a final state of charge SOC_{final}, are acquired, and a displayed SOC change amount ΔSOC_{displayed} corresponding to the discharge range is calculated, where ΔASOC_{displayed}=SOCᵢₙᵢₜᵢₐₗ-SOC_{final}. Only the first piece of data and the last piece of data in a discharge range are acquired, i.e., only the initial state of charge SOCᵢₙᵢₜᵢₐₗ and the final state of charge SOC_{final} are acquired, and the intermediate process is not considered. For example, intermediate data related to battery charging caused by the regeneration phenomenon in the discharge process is not considered, and only the initial state of charge SOCᵢₙᵢₜᵢₐₗ and the final state of charge SOC_{final} are needed. In addition, ΔSOC_{displayed} represents a consumed SOC calculated by the BMS, i.e., an SOC finally displayed on the instrument.
5. A cumulative discharge amount P corresponding to each discharge range and a rated electric quantity (i.e., rated capacity) C of the battery are acquired, and an actual SOC change amount ΔSOC_{actual} corresponding to each discharge process is calculated using the following formula according to the cumulative discharge amount P, the rated electric quantity C, the temperature coefficient k_{T}, and the state of health SOH of the battery: ΔSOC_{actual}=P/(C*µ)*100%, where µ represents a capacity coefficient, which is related to the state of health SOH and the temperature of the battery, and µ=SOH*k_{T}. ΔSOC_{actual} represents a relatively accurate consumed SOC calculated according to the battery current, and is an actual consumed SOC of the battery. The actual capacity of the battery can be accurately estimated by taking the influence of temperature on the battery and the state of health of the battery into consideration.
6. An SOC deviation value k corresponding to each discharge range is calculated using the following formula: k=ΔSOC_{displayed}-ΔSOC_{actual}. The SOC deviation value k represents a deviation between the SOC displayed on the instrument and the SOC calculated according to the actual electric quantity discharged. Assuming that a maximum theoretical deviation of the value range of k is [-k₁,k₁], the calculation result is analyzed as follows:

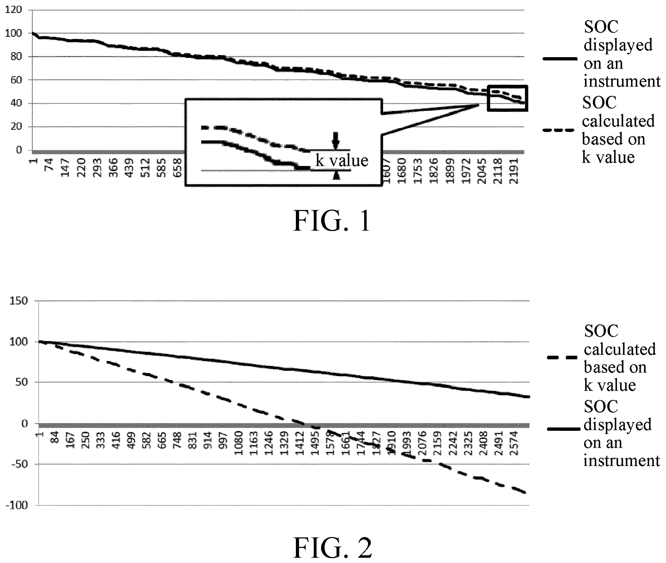

When kE [-k₁,0), the SOC calculated by the BMS is greater than the actual SOC consumed by the battery, indicating that the SOC calculated by the BMS is falsely high. For example, FIG. 1 is a schematic diagram in a discharge range when k<0.

When k ∈(0,k₁], the SOC calculated by the BMS is less than the actual SOC consumed by the battery, indicating that the SOC calculated by the BMS is falsely low.

When k=0, the SOC calculated by the BMS is normal.

In a second step, a normal distribution curve is fit based on a large number of k values, a deviation threshold is determined, and a deviation range is defined according to the deviation threshold, so as to preliminarily analyze and predict a fault type of the battery according to an a size of error and a current operational status of the vehicle. Details are as follows:

Because the accuracy of quantification cannot be evaluated according to the data quality and the SOH parameter, a normal distribution curve may be fit based on absolute values of calculated k values of all discharge ranges. In other words, a distribution range of k values is determined according to mathematical analysis of 3σ±µ (i.e., 3σ criterion) by using k value as the abscissa and the number of k values as the ordinate, i.e., multiple deviation ranges are defined according to deviation thresholds. Multiple deviation thresholds are distinguished, and the deviation thresholds are selected based on the principle of 1>K1>K2>...>Kn>0. In this embodiment, the selected deviation thresholds and a relationship between values of the deviation thresholds is: 1>K1>K2>K3>0, and ki much larger than K1. The corresponding deviation ranges and fault causes (types) are as follows:
1) When k∈(-∞,-k₁]∪[k₁,+∞), i.e., |k|∈[k1,+∞): the k value seriously deviates from the theoretical value, and the cause of fault in the battery cannot be determined. In this case, a check regarding parsing performed by a vehicle-mounted terminal, regarding whether there is an erroneous byte in a BMS-related field in a CAN communication packet, or regarding whether SOH estimation is inaccurate, needs to be performed. In other words,, it is determined whether an anomaly occurs in parsing of background data. As shown in FIG. 2, because the deviation is too large, the actual SOC calculated based on the actual SOC change amount ΔSOC_{actual} already has a value less than 0, indicating that the SOC deviation value k is not within a confidence range. As analyzed according to the actual situation, this is probably caused by the abnormal rated electric quantity C of the battery sent by the BMS.
2) When k∈(-k₁,-K1]∪[K1,k₁), i.e., |k|∈[K1,k₁): this data range is within the theoretical range. However, in this case, the SOC deviation of the vehicle is too large, which may lead to a relatively large number of times of charging for the user. If the number of times of charging is not significantly higher than those of other vehicles, the accuracy of estimation of the state of health SOH of the battery needs to be considered first.
3) When k∈(-K1,-K2]∪[K2,-K1), i.e., |k|∈[K2,K1): the deviation range is defined as serious fault, which is likely to occur in vehicles that have been used for a long period of time or that have been subjected to a large total number of charge and discharge cycles. This range conforms to serious battery aging or battery anomaly. According to the temperature and SOH variables in the k value calculation formula, an anomaly in the battery is preferentially determined. If the values of these two variables are normal, the fault cause points to an SOC correction strategy used by the BMS (where, the SOC correction strategy is a correction strategy used by the BMS to calculates the current SOC of the battery, and the correction strategy includes an accumulative error caused by use of ampere-hour integration), and the current warning level is a high-risk level.
4) When k∈(-K2,-K3]∪[K3,K2), i.e., |k|∈[K3,K2): this deviation range is defined as mild fault. This fault range is usually caused by abnormal correction of the strategy of the BMS. The battery does not have a serious fault. From the perspective of the vehicle, for a vehicle powered by multiple sets of power batteries, the battery temperature needs to be checked. Assuming that the electric quantity available in the current battery core decreases at a temperature of T1, if there is a large temperature difference between different sets of power batteries, e.g., the lowest temperature of a set of power battery is less than or equal to T1 and the lowest average temperature of cells in other sets of power batteries is greater than T1, this fault may also occur. The current warning level is a low-risk level.
5) When k∈(-K3,K3), i.e., |k|∈[0,K3): A theoretical normal value of k should be 0. In practice, due to the influence of an error of the SOC-OCV curve of the battery and the capacity correction strategy, the k value has a reasonable error. When the data calculation result is within the range of (-K3,K3), the deviation range of the k value is defined as normal. Due to the deviation of the SOH and the temperature coefficient, there may be a credible deviation between the actual SOC value and the calculated SOC value.

In a third step, after all the deviation ranges are determined through the first step and the second step, and the battery of this type of vehicle can be troubleshot according to the determined deviation ranges. The specific process is as follows:
1. An initial state of charge SOCᵢₙᵢₜᵢₐₗ and a final state of charge SOC_{final} corresponding to a discharge process of a battery and displayed on an instrument of the vehicle are acquired, and a difference between the two states of charge is calculated to obtain a displayed SOC change amount ΔSOC_{displayed} corresponding to the discharge process: ΔSOC_{displayed}=SOCᵢₙᵢₜᵢₐₗ-SOC_{final}.
2. A cumulative discharge amount P of the discharge process, a rated electric quantity C and a capacity coefficient µ of the battery are acquired, and an actual SOC change amount ΔSOC_{actual} corresponding to the discharge process is determined: ΔSOC_{actual}=P/(C*µ)*100%.
3. A difference between the displayed SOC change amount ΔSOC_{displayed} and the actual SOC change amount ΔSOC_{actual} is calculated to obtain an SOC deviation value k.
4. A deviation range where the SOC deviation value k lies (the deviation range described in the second step) is determined, so as to determine whether an SOC anomaly occurs in the battery system and a cause of the anomaly, and the SOC of the battery system is further troubleshot according to the cause of the anomaly. For a fault with a large deviation, an early warning prompt regarding the fault may be pushed to remind the user to carry out overhaul and maintenance of the vehicle.

To sum up, the method of the present invention specifically has the following characteristics:
1) The actual capacity of the battery is calculated by taking the influence of the state of health of the battery and the temperature of the battery on the battery capacity into consideration, to ensure the accuracy of calculation of the actual battery capacity.
2) The actual SOC change amount ΔSOC_{actual} corresponding to the discharge process is calculated according to the calculated actual capacity of the battery, and the SOC deviation value k can be calculated according to the actual SOC change amount ΔSOC_{actual} and the displayed SOC change amount ΔSOC_{displayed} corresponding to the discharge process, so that the deviation degree of the SOC can be effectively quantified using a specific value, thereby providing a particular dimension for anomaly analysis.
3) A large number of SOC deviation values k are calculated based on a large amount of data collected, normal distribution fitting is performed based on these k values, the deviation thresholds can be determined according to the 3σ criterion, and the deviation ranges can be defined according to the deviation thresholds. In this way, the deviation degree of the SOC can be quantified by using big data and mathematical statistics, providing a basis for anomaly analysis to solve the problem of inaccurate definition of deviation ranges caused by manual determination of deviation ranges.
4) In the present invention, the fault type of the SOC of the battery system can be preliminarily predicted and analyzed, providing a basis for troubleshooting the SOC of the battery system.

### Apparatus embodiment:

An embodiment of the present invention provides an anomaly monitoring and diagnosis apparatus for an SOC of a new energy vehicle. As shown in FIG. 4, the apparatus includes a memory, a processor, and an internal bus. The processor communicates and exchanges data with the memory through the internal bus. The memory includes at least one software function module stored therein. The processor executes software programs and modules stored in the memory to perform various function applications and data processing, to implement the anomaly monitoring and diagnosis method for an SOC of a new energy vehicle in the method embodiment of the present invention.

The processor may be a microprocessor (MCU), a programmable logic device (FPGA), or other processing devices. The memory may be any type of memory storing information in the form of electric energy, e.g., a random access memory (RAM), a read-only memory (ROM), etc.; or may be any type of memory storing information in the form of magnetic energy, e.g., a hard disk, a floppy disk, a magnetic tape, a magnetic core memory, a magnetic bubble memory, a USB flash drive, etc.; or may be any type of memory storing information in an optical form, e.g., a compact disc (CD), a digital versatile disc (DVD), etc. Of course, the memory may also be other types of memories, e.g., a quantum memory, a graphene memory, etc.

### Vehicle embodiment:

An embodiment of the present invention provides a new energy vehicle, which includes a vehicle body and further includes an anomaly monitoring and diagnosis apparatus for an SOC of a battery system of a new energy vehicle, e.g., the anomaly monitoring and diagnosis apparatus for an SOC of a battery system of a new energy vehicle in the apparatus embodiment, which will not be described in detail herein again.

## Claims

1. An anomaly monitoring and diagnosis method for a state of charge (SOC) of a battery system of a new energy vehicle, comprising:
1) acquiring an initial state of charge SOCᵢₙᵢₜᵢₐₗ and a final state of charge SOC_{final} corresponding to a discharge process of a battery and displayed on an instrument of the new energy vehicle, and calculating a difference between the two states of charge to obtain a displayed SOC change amount ΔSOC_{displayed} corresponding to the discharge process;
2) determining an actual SOC change amount ΔSOC_{actual} corresponding to the discharge process according to a cumulative discharge amount of the discharge process, and a rated electric quantity and a capacity coefficient of the battery, wherein the capacity coefficient is related to a state of health of the battery and a temperature of the battery;
3) calculating a difference between the displayed SOC change amount ΔSOC_{displayed} and the actual SOC change amount ΔSOC_{actual} to obtain an SOC deviation value k; and
4) determining a deviation range where an absolute value |k| of the SOC deviation value k lies, to determine whether an SOC anomaly occurs in the battery system, wherein the deviation range is defined according to a deviation threshold, the deviation threshold comprises a first deviation threshold K3, it is determined that no SOC anomaly occurs in the battery system if |k|∈[0,K3), and it is determined that an SOC anomaly occurs in the battery system if |k|∈[K3,+∞).

2. The anomaly monitoring and diagnosis method for an SOC of a battery system of a new energy vehicle according to claim 1, wherein in the step 2), the capacity coefficient is a product of the state of health of the battery and a temperature coefficient, and the temperature coefficient is related to the temperature of the battery.

3. The anomaly monitoring and diagnosis method for an SOC of a battery system of a new energy vehicle according to claim 1, wherein in the step 4), the deviation threshold further comprises a deviation threshold greater than the first deviation threshold K3, and for deviation ranges defined according to the deviation threshold greater than or equal to the first deviation threshold K3, each deviation range corresponds to an anomaly cause; and after it is determined that an SOC anomaly occurs in the battery system, a corresponding anomaly cause is determined according to the deviation range where the absolute value |k| of the SOC deviation value k lies.

4. The anomaly monitoring and diagnosis method for an SOC of a battery system of a new energy vehicle according to claim 3, wherein the deviation threshold greater than or equal to the first deviation threshold K3 further comprises a second deviation threshold K2, and K2>K3; and if |k|∈[K3,K2), it is determined as a mild fault occurs, and the corresponding anomaly causes comprise: a correction strategy used by a battery management system to calculate a battery SOC to be displayed is abnormal.

5. The anomaly monitoring and diagnosis method for an SOC of a battery system of a new energy vehicle according to claim 4, wherein the deviation threshold greater than or equal to the first deviation threshold K3 further comprises a third deviation threshold K1, and K1>K2; and if |k|∈[K2,K1), it is determined as a serious fault occurs, and the corresponding anomaly causes comprise at least one of them: the battery has been used for more than a set life threshold, a total number of charge and discharge cycles of the battery is greater than a set cycle threshold, and a correction strategy used by a battery management system to calculate a battery SOC to be displayed is abnormal.

6. The anomaly monitoring and diagnosis method for an SOC of a battery system of a new energy vehicle according to claim 5, wherein the deviation threshold greater than or equal to the first deviation threshold K3 further comprises a third deviation threshold k₁, and k₁>K1; and if |k|∈[K1,k₁), the corresponding anomaly causes comprise at least one of them: a number of times of charging of the battery is greater than a set charging number threshold, and estimation of the state of health of the battery is abnormal.

7. The anomaly monitoring and diagnosis method for an SOC of a battery system of a new energy vehicle according to claim 6, wherein if |k|∈[k1,+∞), the corresponding anomaly causes comprise: data used by the battery management system to calculate the battery SOC to be displayed is abnormal, and data used by the battery management system to calculate the state of health of the battery is abnormal.

8. The anomaly monitoring and diagnosis method for an SOC of a battery system of a new energy vehicle according to any one of claims 1 to 7, wherein a method of determining the deviation threshold comprises:
acquiring a plurality of discharge processes, and obtaining a plurality of SOC deviation values k by using the same method as that used in the steps 1) to 3);
fitting a normal distribution curve with the SOC deviation value k as an abscissa and a number of times of appearance of the SOC deviation value k as an ordinate; and
determining the deviation threshold according to a 3σ criterion of normal distribution.

9. An anomaly monitoring and diagnosis apparatus for a state of charge (SOC) of a battery system of a new energy vehicle, comprising a memory and a processor, wherein the processor is configured to execute instructions stored in the memory to implement the anomaly monitoring and diagnosis method for an SOC of a battery system of a new energy vehicle according to any one of claims 1 to 8.

10. A new energy vehicle, comprising a vehicle body and further comprising the anomaly monitoring and diagnosis apparatus for a state of charge (SOC) of a battery system of a new energy vehicle according to claim 9.
